# EUROPEAN PATENT APPLICATION

(11) **EP 2 521 188 A1**
(43) Date of publication of application: **07.11.2012**
(21) Application number: 12166057.5
(22) Date of filing: 27.04.2012
(51) Int. Cl.: H01L 31/048

(54) **Photovoltaic module in the shape of an architectural element and process for the realization thereof**

(30) Priority: 02.05.2011 IT MI20110731
(71) Applicant: Quagliato, Giovanni Battista, 36040 Grumolo Delle Abbadesse (VI) (IT)
(72) Inventor: Quagliato, Giovanni Battista, 36040 Grumolo Delle Abbadesse (VI) (IT)
(74) Representative: Finetti, Claudia

(57) **Abstract**

The present invention refers to a photovoltaic module in the shape of an architectural element and to a process for the realization thereof, preferably, but not exclusively, used in the building industry, in which the photovoltaic module in the shape of an architectural element comprises a body (15) in the shape of an architectural element to be simulated in which at least one photovoltaic cell (11) is integrated, such to be not visible, the at least one photovoltaic cell (11) being provided with at least two terminals (12) which exit from the body (15) for connecting with an electric energy accumulation system (20), and an anchoring support 16 coupled with the body (15), and it is characterised in that the body (15) in the shape of an architectural element is constituted by a single layer of material opaque at the wavelengths corresponding to the colours of the architectural element to be simulated and transparent at the remaining wavelengths of the solar radiation spectrum.

## Description

The present invention refers to a photovoltaic module in the shape of an architectural element and a process for the realization thereof, preferably, but not exclusively, used in the building industry.

Nowadays, the photovoltaic module market is getting a strong stimulus due to the growing need of finding a sustainable source of electric energy both in terms of cost, and in terms of environment protection. It is currently known to make photovoltaic plants intended to integrate the supply of electric energy from the national electric distribution network; such plants are generally installed on the roofs of buildings to which they provide electric energy through the use of special supports that are suitable for keeping the optimal orientation of the photovoltaic module with respect to the horizon.

It is moreover known to make photovoltaic plants for the realization of actual power plants; in such a case, the photovoltaic modules are generally positioned on flat and sunny ground.

The development of photovoltaic plants nationally and internationally imposes the requirement of integrating such plants with the surrounding environment so as to ensure the visual continuity and the pleasant appearance thereof.

However, the photovoltaic modules used to this day do not integrate with the surrounding architectural elements, be they building elements, urban decorations or natural elements, such as stones for gardens, parks, swimming pools and small lakes, being seen as a foreign body to the surrounding environment.

This risks to slow down the process of spreading of photovoltaic plants, which can in reality have a very important role in reducing the energy dependence on petrol supply of many countries, including Italy.

The purpose of the present invention is that of avoiding the aforementioned drawbacks and in particular that of providing a photovoltaic module which is capable of being integrated with the architectural elements and with the surrounding environment.

Another purpose of the present invention is that of devising a process for the realization of a photovoltaic module according to the invention.

These and other purposes according to the present invention are achieved by making a photovoltaic module in the shape of an architectural element and a process for the realization thereof, as outlined in the independent claims 1 and 8.

Further characteristics of the photovoltaic module in the shape of an architectural element and of the process for the realization thereof are object of the dependent claims.

The characteristics and the advantages of a photovoltaic module in the shape of an architectural element and of a process for the realization thereof, according to the present invention, shall become clearer from the following description, given as an example and not for limiting purposes, with reference to the attached schematic drawings, in which:

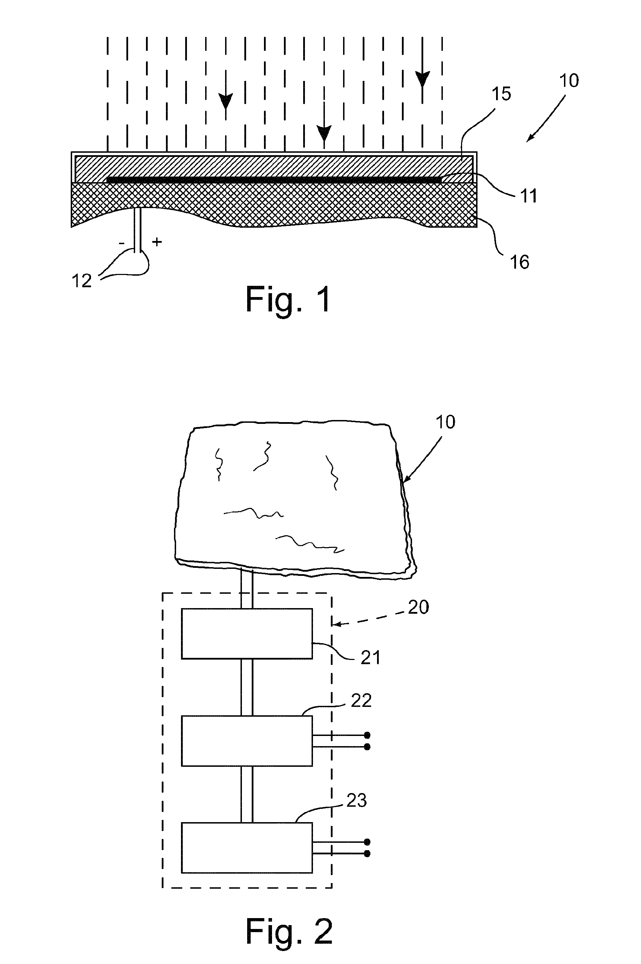

- figure 1 is a schematic view of an embodiment of a photovoltaic module in the shape of an architectural element according to the present invention in the operative configuration;
- figure 2 is a schematic view of the photovoltaic module of figure 1 connected to an electric energy accumulation system represented by a block diagram;

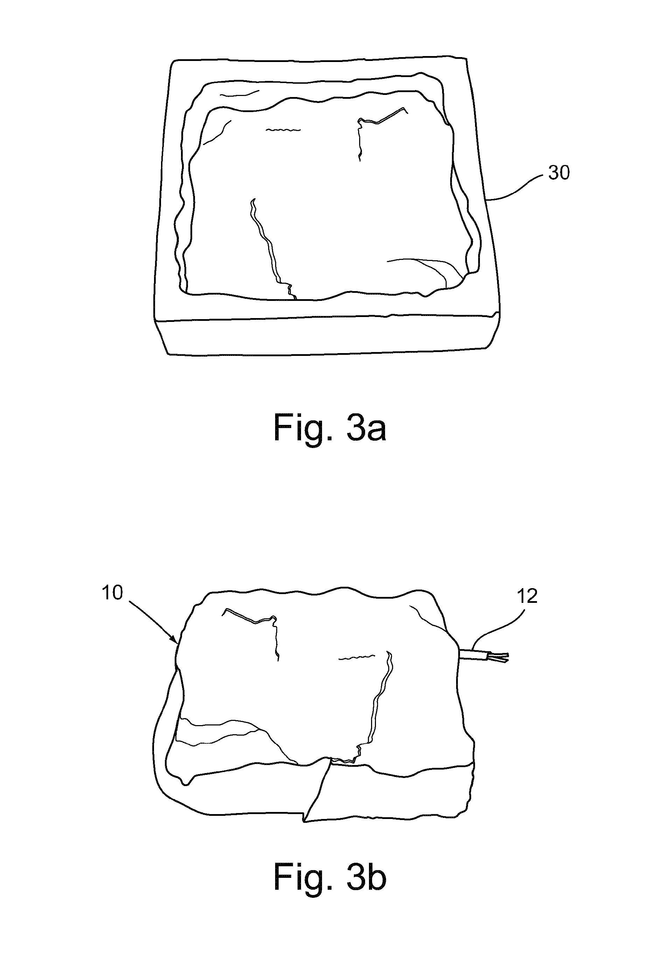

- figure 3a is a perspective view of a first mould of the open type for the realization of the photovoltaic module of figure 1;
- figure 3b is a perspective view of the photovoltaic module in the shape of a stone made by means of the mould of figure 3a;

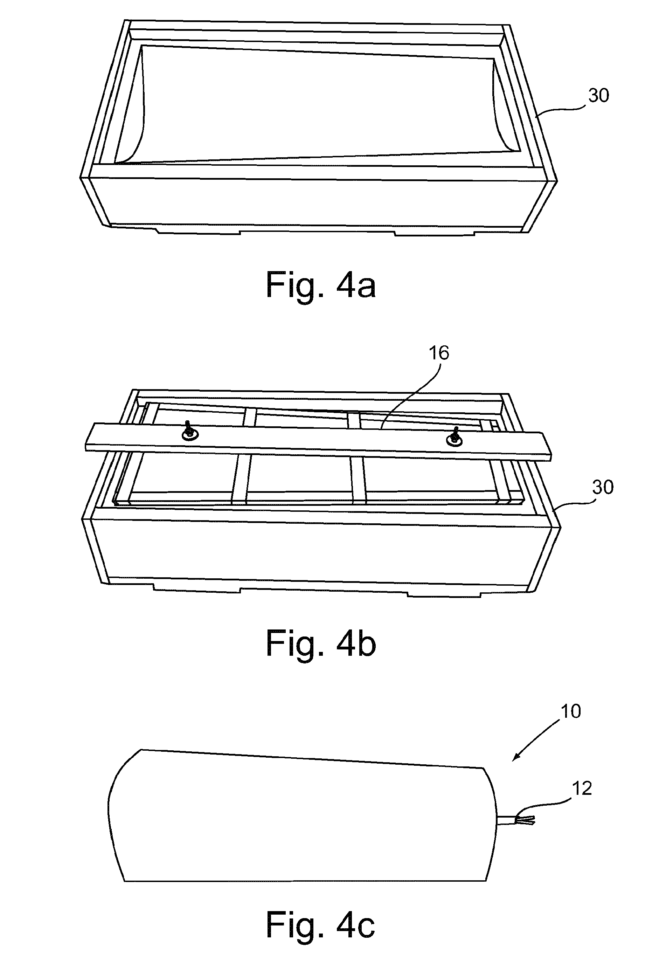

- figures 4a and 4b are two perspective views of a second mould, of the open type and of the closed type, respectively, for the realization of the photovoltaic module of figure 1;
- figure 4c is a perspective view of the photovoltaic module in the shape of a tile made by means of the mould of figure 4a or 4b;

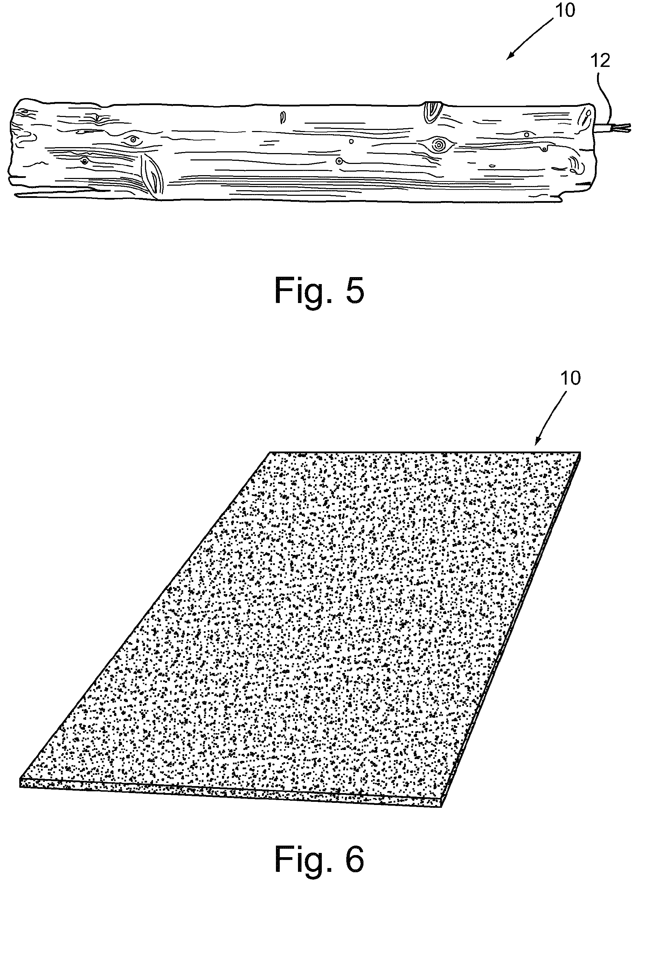

- figure 5 is a top view of the photovoltaic module in the shape of wooden board;
- figure 6 is a perspective view of the photovoltaic module in the shape of mortar panel;

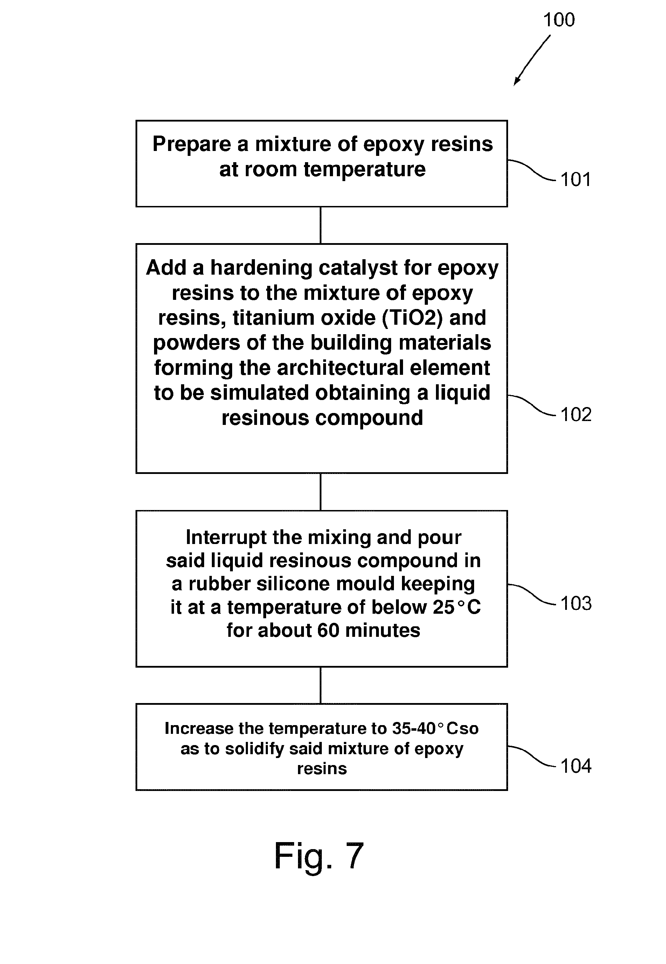

- figure 7 is a flow chart related to the process for the realization of the photovoltaic module of figures 1, 3b, 4c, 5 and 6;
- figure 8 is a current-voltage graph related to the photovoltaic module according to the present invention;
- figure 9a is a graph showing the measurements in darkness of the current density according to the voltage in conditions of forward bias of the photovoltaic module considered in the graph of figure 8;
- figure 9b is a graph showing the measurements in darkness of the current density as a function of the voltage in conditions of reverse bias of the photovoltaic module considered in the graph of figure 8;
- figure 9c is a graph showing the measurements in darkness of the logarithm of the current density as a function of the voltage in conditions of forward bias of the photovoltaic module considered in the graph of figure 8;
- figure 10 is a Nyquist diagram obtained by means of experimental measurements in darkness carried out on the photovoltaic module considered in the graph of figure 8;

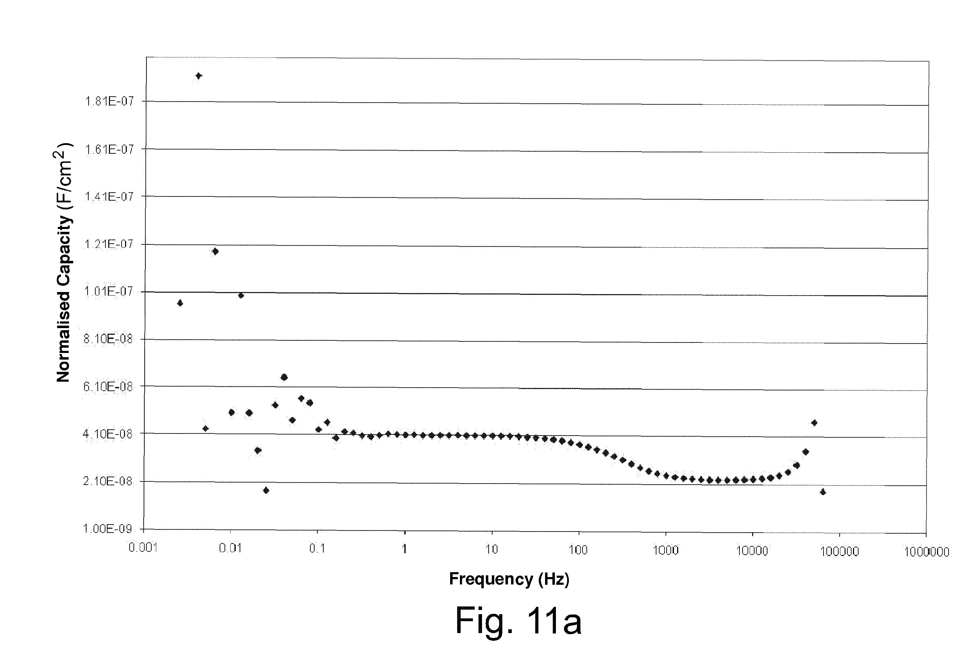

- figure 11a is a graph showing the measurements of the normalised capacity per unit area and per cell as a function of the frequency, carried out on the photovoltaic module considered in the graph of figure 8;

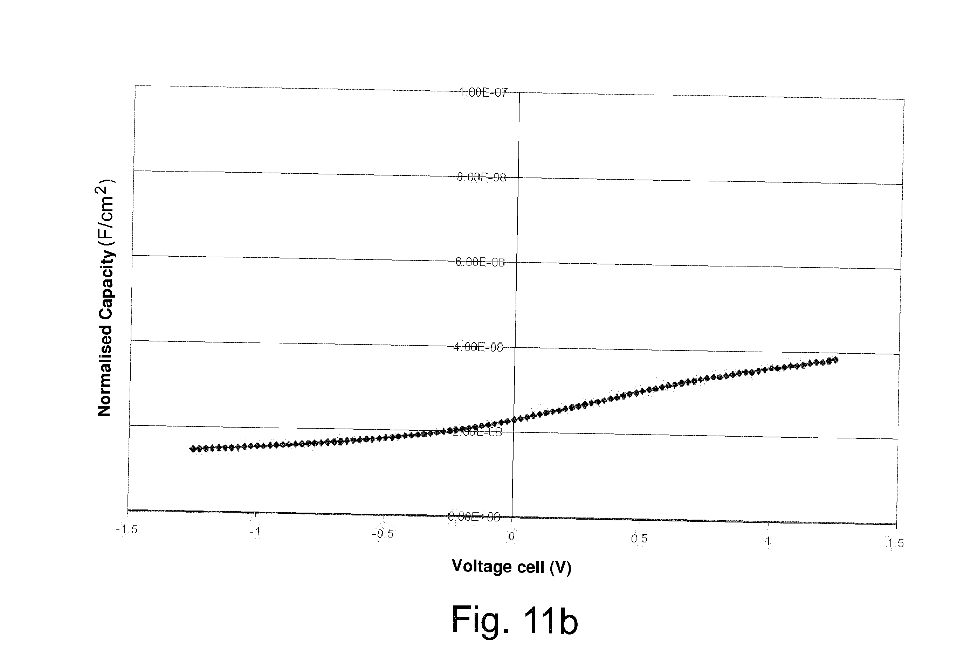

- figure 11b is a graph showing the measurements of the normalised capacity per unit area and per cell as a function of the voltage, carried out on the photovoltaic module considered in the graph of figure 8;

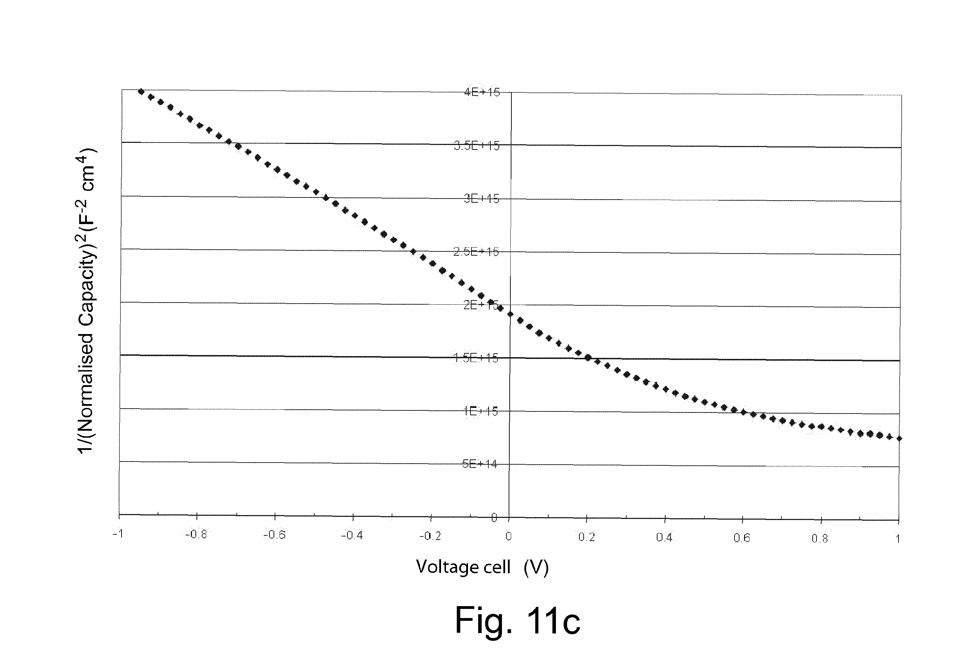

- figure 11c is a graph showing the measurements of the reciprocal of the normalised capacity per unit area and per cell as a function of the voltage, carried out on the photovoltaic module considered in the graph of figure 8.

With reference to the figures, a photovoltaic module is shown in the shape of an architectural element, like for example a stone or roof tile or tile, wholly indicated with reference numeral 10.

Such a photovoltaic module 10 comprises at least one photovoltaic cell 11 that is provided with at least two terminals 12 for connecting to the electric energy accumulation system 20. The electric energy accumulation system 20, in detail, in turn comprises a charge regulator 21 directly connected on one side to the photovoltaic cell 11 and on the other side to an accumulator 22, like for example a battery. The charge regulator 21, therefore, is suitable for stabilizing the energy produced by the photovoltaic cell 11 and sending it to the accumulator 22.

Preferably, such an accumulator 22 comprises one or more rechargeable batteries that are connected to one another in series and/or in parallel suitable for storing the electric charge provided by the photovoltaic module so as to allow a later use by electric user apparatuses.

The accumulator 22 is finally connected to a direct current/alternating current or d.c./a.c. converter, also called inverter, which is suitable for converting the direct voltage in outlet from the panel, preferably comprised between 12 and 24 V, to a higher alternating voltage, preferably comprised in the range of voltages 110-230 V for plants up to a few kW and 110-400 V for plants with power beyond 5 kW.

According to the present invention, the photovoltaic module 10 comprises a body 15 in the shape of an architectural element to be simulated in which the photovoltaic cell 11 is drowned so as to not be visible. It should be underlined that, although the photovoltaic cell 11 is completely integrated inside the body 15, the at least two terminals 12 of such a cell 11 exit from the body itself 15 so as to be easily connected to the electric energy accumulation system 20.

The body 15 in the shape of an architectural element is constituted by a single layer of material opaque and in particular reflecting at the wavelengths corresponding to the colours of the architectural element to be simulated and transparent at the remaining wavelengths of the solar radiation spectrum. Such a radiation spectrum comprises the wavelengths ranging from 0.35 µm, up to 10 µm, that is from the ultraviolet to infrared.

Preferably, the photovoltaic module 10 has the shape of a stone.

Preferably, the photovoltaic module 10 has the shape of a tile.

Preferably, the photovoltaic module 10 has the shape of a coating element for floors and/or walls like for example a mortar panel.

Preferably, the photovoltaic module 10 has the form of a wooden board, particularly for covering walls, covering roofs, wooden elements for doors and windows. Preferably, the body 15 in the shape of an architectural element is constituted by an epoxy resin-based compound mixed with loads like oxides and/or colouring earths, so that the body itself 15 has the same appearance as the one of the building material of the reference architectural element.

In particular, the compound used for incorporating the photovoltaic cell is a polymer compound constituted by a mixture of liquid epoxy resins, which is subsequently hardened.

Preferably, such an epoxy resin mixture comprises epoxy resins each of which has the following physical-chemical characteristics:
- Gardner colour (Gardner proof method) comprised in the range between 2 and 5, where in particular the values 2, 4 and/or 5 are preferred; and/or
- Brooksfield viscosity at 25° C (test method MA 041 LCP) comprised in the range between 350 and 750 cPs, preferably comprised between 400 and 700 cPs, where in particular the preferred values are 400, 600 and/or 700 cPs; and/or
- Specific weight (measuring method ISO 2811) comprised in the range between 1100 and 1150 kg/m³, where, in addition to values of the extremes of the range, the values 1110 and/or 1140 kg/m³ are particularly preferred; and/or
- Flash Point (PMCC) (test method ASTM-D-93) higher than 150° C.

Advantageously, the photovoltaic module 10 comprises an anchoring support 16 coupled with the body 15 in the shape of an architectural element. Such an anchoring support 16 is suitable for coupling with other architectural elements so as to create a covering surface for walls or a wall.

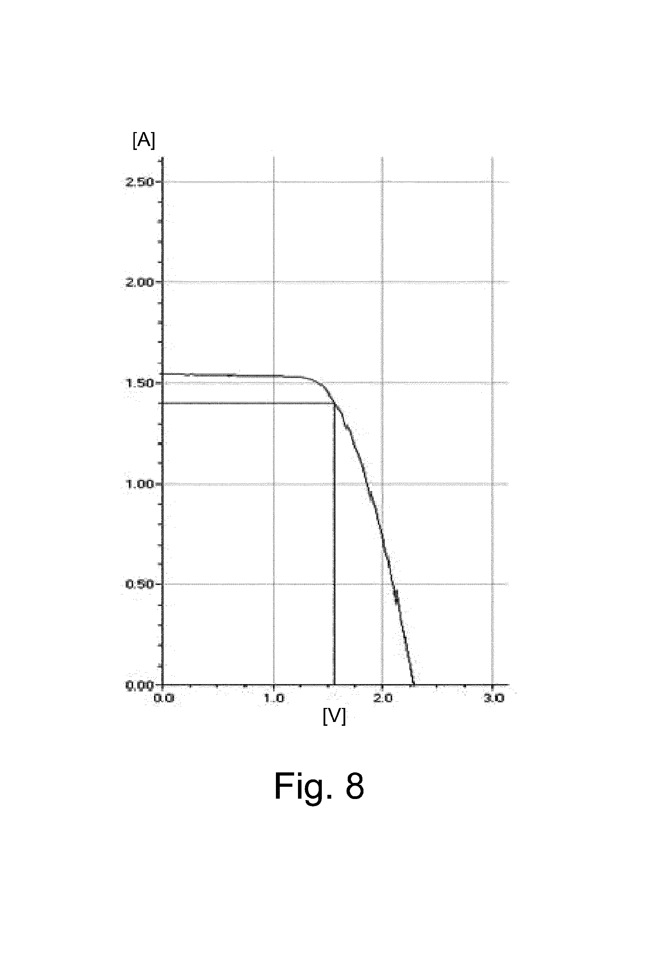

In a particular embodiment, the photovoltaic module 10 has the shape of a tile of about 717 cm² in which the photovoltaic cell in polycrystalline silicon has dimensions 8x15.24 cm² that is 121.92 cm². Figure 8 shows the characteristic current-voltage obtained by carrying out measurements on the aforementioned photovoltaic module 10 at the STC conditions (irradiance of 1000 W/m⁻², junction temperature of 25°C and reference spectral distribution of the solar radiation according to IEC 60904-3).

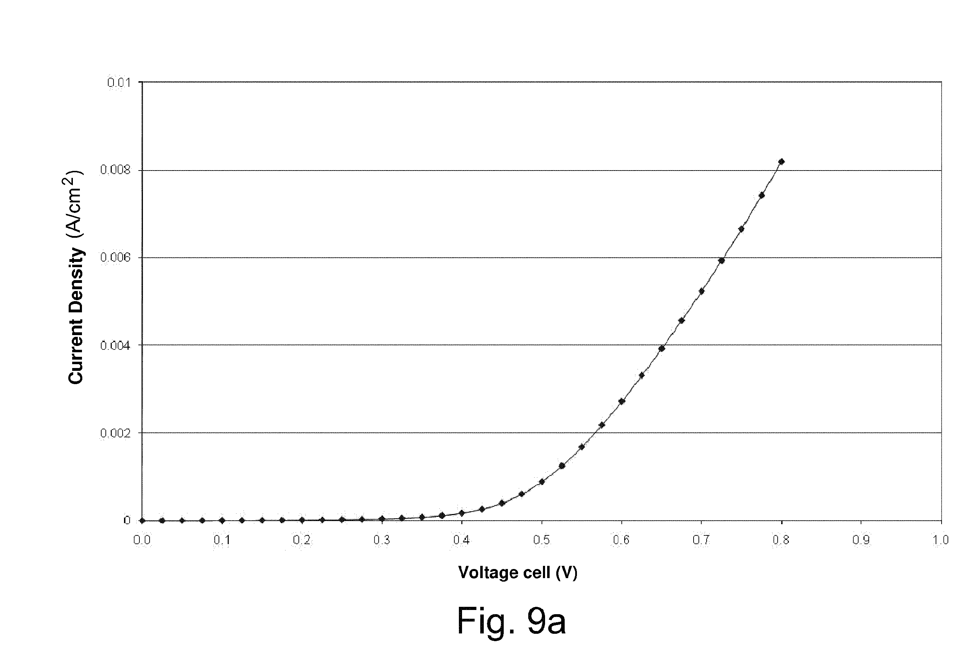

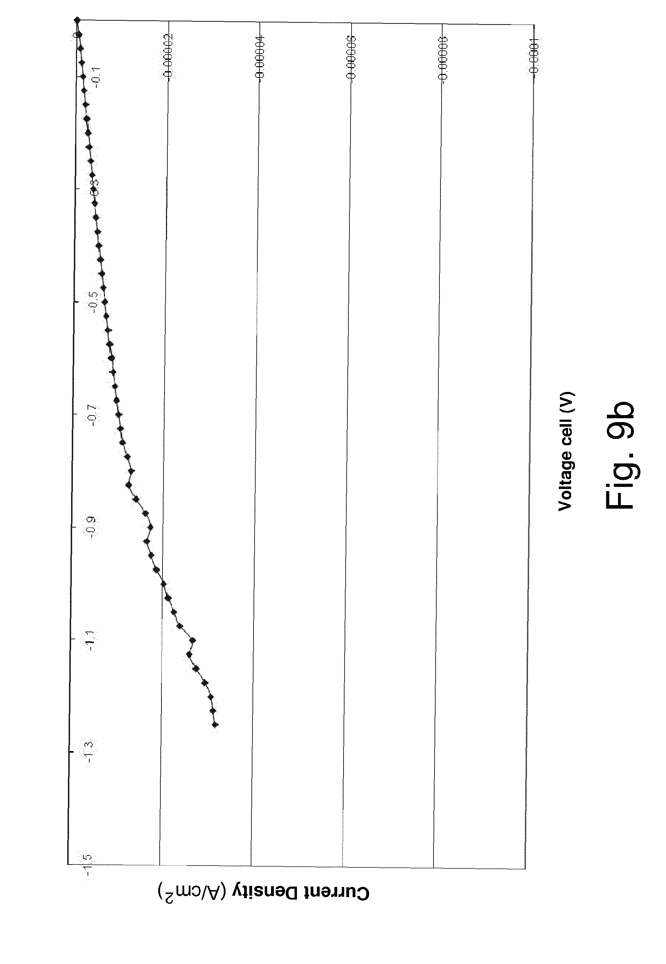

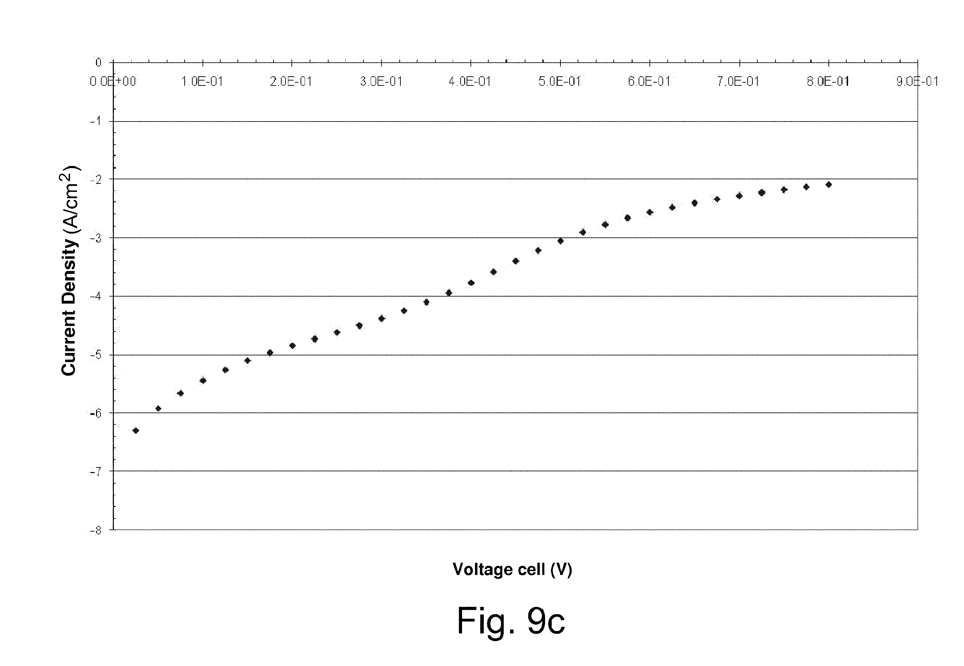

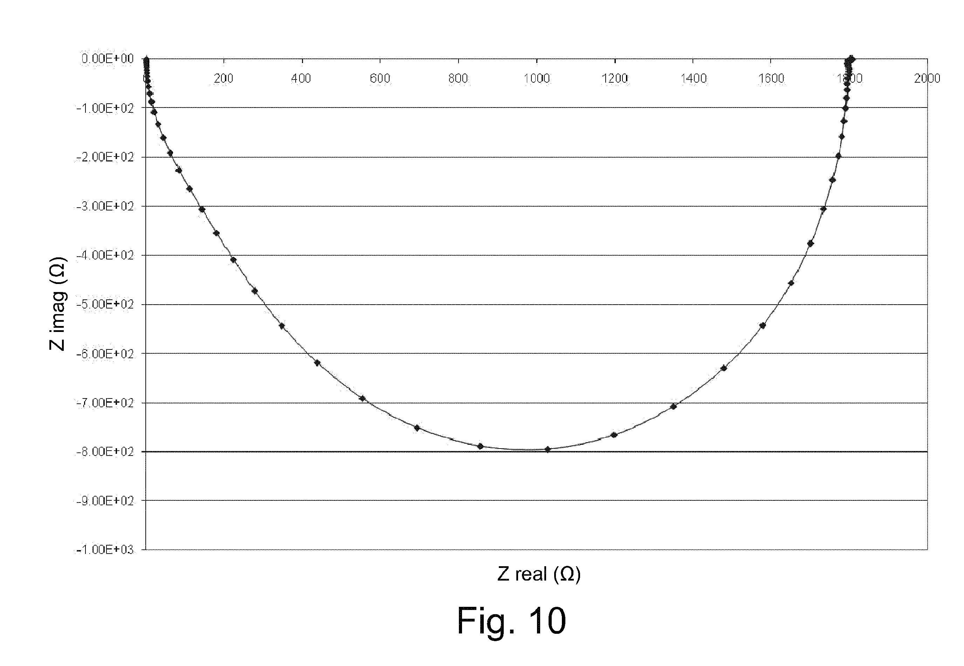

On such a photovoltaic module 10 also a current-voltage or I-V investigation in darkness was carried out which can be observed in figures 9a, 9b and 9c. Such an investigation I-V in darkness consists of polarizing with a source of direct current, direct or reverse, the module 10 that has not been irradiated, tracing the electric characteristic thereof; from the analysis of the curve it is possible to derive useful information for the understanding of the characteristics and of the quality of the module 10, such as the diode factor, the reverse saturation current, the threshold voltage and the possible presence of the avalanche effect. It is worth underlining that the measurements are carried out by connecting the photovoltaic module 10 to a direct current power generator as applied electric load. In figure 10 it is possible to observe the results of the frequency investigation in darkness carried out on the same photovoltaic module 10. Such a frequency investigation in darkness consists of applying to the non irradiated device a signal of a suitable frequency and amplitude and studying the response; from the analysis of the illustrated curve it is possible to derive useful information for understanding the characteristics and the quality of the module 10, such as the parameters of series and parallel resistance, the mismatching of the cells, the built-in voltage, the thickness of the depletion region. On the considered photovoltaic module 10 for the measurements a capacitive investigation has been moreover carried out. The capacitive measurements can be separated into capacitive measurements as a function of the frequency and into capacitive measurements as a function of the bias voltage. The first explore the capacitive behaviour of the module as a function of the frequency and show variations due to the different response time with respect to the frequency of the signal. Moreover such capacitive measurements as a function of the frequency are useful for determining the thickness of the depletion region by calculating the value of the capacity in the region at high frequency (hundreds of KHz) and for determining states of defect or of extra charge for materials, amorphous and crystalline, respectively, by calculating the value of the low frequency capacity (below the Hz). The second ones, on the other hand, investigate the complex behaviour of the junctions as a function of the voltage polarity (direct or reverse) and to the intensity bias. Different regions can be identified in which junction capacity (for values of reverse voltage) and the diffusion capacity for charge variations at values of high forward bias, which can be correlated to the average life span of the charge carriers, prevail. Moreover, if we presume a certain distribution of the ionized impurities, it is possible to determine the junction barrier potential.

The process 100 for the realization of the photovoltaic module comprises an initial step 101 that consists of preparing a mixture of epoxy resins.

Such initial resins are mixed at the room temperature, i.e. at temperatures of around 20° C and for the entire mixing step, the temperature is kept between 20° C and 25° C.

In one embodiment the epoxy resin mixture is prepared by mixing at least three epoxy resins respectively having the following percentages with reference to the total amount of the initial resins:
- the first epoxy resin is 20% present in the mixture and has the following characteristics:
   - Gardner colour (Gardner proof method) value 5 Max; and
   - Brooksfield viscosity at 25° C (test method MA 041 LCP) 600±50 cPs; and
   - specific weight (measuring method ISO 2811) comprised in the range between 1140 and 1150 kg/m³; and
   - Flash Point (PMCC) (test method ASTM-D-93) higher than 150° C.
- the second epoxy resin is 35% present in the mixture and has the following characteristics:
   - Gardner colour (Gardner proof method) value 4 Max; and
   - Brooksfield viscosity at 25° C (test method MA 041 LCP) 700±50 cPs; and
   - specific weight (measuring method ISO 2811) comprised in the range between 1100 and 1110 kg/m³; and
   - Flash Point (PMCC) (test method ASTM-D-93) higher than 150° C.
- the third epoxy resin is 45% present in the mixture and has the following characteristics:
   - Gardner colour (Gardner proof method) value 2 Max; and
   - Brooksfield viscosity at 25° C (test method MA 041 LCP) 400±50 cPs; and
   - specific weight (measuring method ISO 2811) comprised in the range between 1100 and 1110 kg/m³; and
   - Flash Point (PMCC) (test method ASTM-D-93) higher than 150° C.

Once the mixing of the resins has finished, the process 100 foresees a step consisting of adding 102 a hardening catalyst for epoxy resins, that is a liquid cycloaliphatic amine with the following characteristics:
- Gardner colour (Gardner proof method) value 4 Max; and
- Brooksfield viscosity at 25° C (test method MA 041 LCP) comprised in the range between 30 and 60 mPa.s; and
- active substance 100%; and
- amine number comprised in the range of 260 and 285 mg KOH/g; and
- use ratio with 100 parts of epoxy resin equal to 60%; and
- pot life 40' 00" (measuring unit: minutes).

The hardening catalyst is incorporated in the previously mixed resins in a percentage preferably comprised between 55% and 60%, with reference to the total percentage weight of the resins, as a function of the air humidity and of the room temperature, where in more humid environments a greater amount of catalyst is used.

In particular, at a room temperature of 15°C and with high humidity, that is with a relative humidity of between 50% and 100%, 60% of the hardening catalyst will be used, whereas in dry environments, that is at a relative humidity of between 20% and 50%, at a temperature of 30°C a percentage of 55% of the hardening catalyst is used; in such a way the two catalysation times will be the same.

In the step 102 of adding the hardening catalyst it is moreover foreseen to mix titanium oxide (TiO₂) in a percentage of between 1% and 10%, with reference to the total percentage weight of the mixed resins and loads, preferably constituted by powders of the building materials forming the architectural elements to be simulated. For example, colouring earths, oxides, brickwork powders, such as brick powder, and so on, can be added.

The composition of such powders of building materials varies according to the architectural element to be simulated, as long as they are very fine powders to be used in relation to a purely indicative percentage of around 0.5%-5% with reference to the total percentage weight of the resins, preferably 3%, which can change according to the colour of the powders.

In order to make for example a tile, baked clay powder can be used, in which Baltimore oxide can be added in order to emphasise the redness, Cyprus umber can be added in order to obtain a burned effect, ideal *Basso Polesine* and natural *earth of Siena* can be added for the baked colour.

It should be underlined that the titanium oxide, being a colouring, modifies the final colour of the object, therefore for having a red brick an amount of titanium oxide will be added corresponding to 1% of the overall weight percentage of the resinous mixture, whereas for a white stone an amount of titanium oxide will be added corresponding to 10% of the overall percentage weight of the resinous mixture; in any case, since titanium dioxide takes a rather long time to deposit on the bottom of the container (mould) containing the resin, a high percentage of titanium dioxide decreases the overall transparency.

With the process described above a liquid resin compound is obtained.

When the liquid resin compound is homogeneous the mixing is interrupted and it is poured 103 in a mould 30, made of silicone rubber, keeping it at a temperature lower than 25° C for about 60 minutes, so as to slow down the beginning of the catalysation and allow the deposition of the loads.

In such a way, the loads are deposited on the bottom of the mould, so that the inner volume becomes transparent again.

The moulds can be of the closed type, as shown in the figures or of the open type.

In the case in which moulds of the closed type are used, once the anchoring support 16 fixedly connected to the photovoltaic cell 11 has been positioned, the whole inner space is filled with the liquid resin compound by means of injection. On the other hand, in the case in which moulds of the open type are used, there is the incorporation by drowning of the photovoltaic cell 11 and later the anchoring support 16 is applied.

Preferably, the photovoltaic cell 11 can be made with amorphous silicon, or layers of photovoltaic paints or photovoltaic organic compounds which are drowned in the liquid resin compound.

Therefore, the temperature is raised 104 to 35-40° C and is kept for the period of time necessary for hardening the resins, preferably for a period of time comprised between 1 and 3 hours, even more preferably for about 2 hours.

The resin polymerizes fixing the loads contained in it so as to simulate the appearance of a common architectural element and at the same time be transparent to the remaining wavelengths belonging to the solar radiation spectrum.

In such a way the photovoltaic module 10 is obtained in the shape of an architectural element according to the present invention.

From the preceding description the characteristics of the photovoltaic module and of the process for the realization thereof object of the present invention should be clear, just as the relative advantages should also be clear.

The photovoltaic module according to the present invention has an appearance similar to the materials normally used in architectonic building, for example for covering roofs, for covering fences, walls, terraces, road pavings, covering of buildings and so on. In particular, it is possible to mimic the appearance of stones, rocks, roof tiles, bricks, tiles and objects made from terracotta, panels made from mortar, wood and metal.

The photovoltaic cell thus remains hidden, but perfectly operational, since the epoxy resin-based compound used is transparent at the wavelengths of the light necessary for producing electric energy.

The photovoltaic module obtained by the process according to the present invention also has a considerable series of advantages. Indeed, hardened resins, that is polymerised resins, are non-toxic and when they are heated to a predetermined temperature of around 800°C they decompose, thus allowing the recovery and recycling first of the mixed loads, then of the photovoltaic cells, which melt at much higher temperatures.

The photovoltaic module according to the present invention is also equipped with a considerable resistance to the mechanical forces (optimal resistance to impact and to compression at room temperature, increasing the plasticity at the expense of the resistance to compression only beyond 163°C), to chemical, physical reactions and to thermal shock of the environment. The ingress protection of powders and liquids is certified IP68 according to the standard UNI EN60529. The photovoltaic module according to the invention can also operate as a thermal brake and electric insulator.

It should also be considered that the titanium dioxide (TiO₂) present in the mixture of hardened resin has the great advantage of conferring self-cleaning and depolluting qualities to the finished product. In fact, titanium dioxide is a semiconductor, catalyst of a photocatalytic reaction for forming two reactive oxygen species, that is superoxide anion and hydroxyl radical, which occurs at the ultraviolet wavelength (400-315 nm). Said reactive species oxidise the organic and inorganic pollutants, the volatile organic compounds and the nitrogen oxides produced by human activity, just like they destroy fungi, bacteria and viruses.

The polluting substances are transformed into salts, which are easily washed away from the treated surfaces by rain and wind. Indeed, on the surfaces treated with titanium dioxide subjected to ultraviolet or UV light, thanks to the extremely small contact angle between the surface treated and water, a sheet of water forms within which the salts formed by catalytic reaction diffuse, becoming easily eliminated.

The photovoltaic module of the present invention, produced with the epoxy resins and with the process described above, are thus maintained clean, modifying through photocatalysis the polluting substances deposited above them, which are then removed by wind and rain.

The photovoltaic module, such as roof tiles and tiles obtained with the process of the present invention, can be used to replace the tiles or roof tiles for covering a roof, hooking them to each other in series and in parallel, through suitable connectors, obtaining a photovoltaic plant integrated with the surrounding architectural environment.

In the case of photovoltaic stones, after the positioning through hooking, the fixing is carried out by using mortar like for common stones. Or the photovoltaic stones can be collected into panels. In this case, it is possible to intervene to obtain photovoltaic systems integrated in areas, like mountain areas, where the roofs are covered with stone, or the external walls exposed to sunlight can be covered, where the photovoltaic stones can be anchored directly to the walls through mortar or forming a coat.

Finally, the mortar photovoltaic panels are useful where terraces are more common than roofs.

It is finally clear that the photovoltaic module and the process for the realization thereof thus conceived can undergo numerous modifications and variants, all covered by the invention; moreover, all the details can be replaced by technically equivalent elements. In practice, the materials used, as well as the dimensions, can be any according to the technical requirements.

## Claims

1. A photovoltaic module in the shape of an architectural element, comprising a body (15) in the shape of an architectural element to be simulated, in which at least one photovoltaic cell (11) is integrated, such to be not visible, said at least one photovoltaic cell (11) being provided with at least two terminals (12) which exit from said body (15) for connecting with an electric energy accumulation system (20) and an anchoring support (16) coupled with said body (15), **characterized in that** said body (15) in the shape of an architectonic element is constituted by a single layer of material opaque at the wavelengths corresponding to the colours of the architectonic element to be simulated, and transparent at the remaining wavelengths of the solar radiation spectrum.

2. The photovoltaic module in the shape of an architectonic element according to claim 1, **characterized in that** said body (15) in the shape of an architectonic element is constituted by an epoxy resin-based compound mixed with oxides and/or coloring earths such that said body (15) has the same appearance as the one of the building material of the architectonic element to be simulated.

3. The photovoltaic module in the shape of an architectonic element according to claim 1 or 2, **characterized in that** said mixture of epoxy resins comprises epoxy resins each of which has the following characteristics:
- Gardner color (Gardner proof method) comprised in the range between 2 and 5;
- Brooksfield viscosity at 25°C (test method MA 041 LCP) comprised in the range between 350 and 750 cPs;
- specific weight (measuring method ISO 2811) comprised in the range between 1100 and 1150 kg/m³;
- Flash Point (PMCC) (test method ASTM-D-93) higher than 150°C.

4. The photovoltaic module in the shape of an architectonic element according to one of the preceding claims, **characterized in that** it has the shape of a stone.

5. The photovoltaic module in the shape of an architectonic element according to one of claims 1 to 3, **characterized in that** it has the shape of a tile.

6. The photovoltaic module in the shape of an architectonic element according to one of claims 1 to 3, **characterized in that** it has the shape of a coating element for floors and/or walls.

7. The photovoltaic module in the shape of an architectonic element according to one of claims 1 to 3, **characterized in that** it has the shape of a wooden board.

8. A process for the realization of a photovoltaic module according to one or more of the preceding claims, comprising the following steps, consisting in:
- preparing (101) a mixture of epoxy resins, mixed at the room temperature;
- adding (102) to said mixture of epoxy resins a hardening catalyst for epoxy resins and titanium oxide (TiO₂) in a percentage preferably comprised between 1% and 10% with reference to the total percentage weight of the mixed resins and loads, preferably constituted by powders of the building materials, forming the architectonic element to be simulated, by obtaining a liquid resin compound;
- interrupting the mixing and pouring (103) said liquid resin compound in a silicone rubber mould, by keeping it at a temperature lower than 25°C for about 60 minutes;
- raising (104) the temperature at 35°-40°C in order to solidify said epoxy resin mixture.

9. The process for the realization of a photovoltaic module according to claim 8, **characterized in that** said catalyst is a liquid cycloaliphatic amine with the following characteristics:
- Gardner colour (Gardner test method) with a value 4 Max; and
- Brooksfield viscosity at 25°C (test method MA 041 LCP) comprised within a range between 30 and 60 mPa.s; and
- active substance 100%; and
- amine number comprised in the range between 260 and 285 mg KOH/g; and
- use ratio with 100 parts of epoxy resin equal to 60%; and
- pot life 40' 00' (measuring unit: minutes).

10. The process for the realization of a photovoltaic module according to claim 8 or 9, **characterized in that** after said raising step of the temperature, is provided the step consisting in keeping the temperature raised for a period of time comprised between one and three hours.

11. The process for the realization of a photovoltaic module according to one of the claims from 8 to 10, **characterized in that** after said raising step of the temperature, is provided the step consisting in keeping the temperature raised for a period of time of about two hours.

12. The process for the realization of a photovoltaic module according to one of the claims from 8 to 11, **characterized in that** in the case in which a silicon rubber mould of the closed type is used, once positioned inside said mould an anchoring support (16) being bound to a photovoltaic cell (11), all the inner space of said mould is filled with said liquid resin compound, by means of an injection.

13. The process for the realization of a photovoltaic module according to one of the claims from 8 to 12, **characterized in that** in the case in which a silicone rubber mould of the open type is used, the incorporation by drowning of said photovoltaic cell (11) in said liquid resin compound is actuated, and later said anchoring support (16) is applied.
